**Europäisches Patentamt**

**European Patent Office**

**Office européen des brevets**

(19)

(11) Veröffentlichungsnummer: **0 141 179**
**A2**

(12) # EUROPÄISCHE PATENTANMELDUNG

(21) Anmeldenummer: **84110783.2**

(22) Anmeldetag: **10.09.84**

(51) Int. Cl.⁴: **H 01 L 23/56**

(30) Priorität: **28.09.83 DE 3335195**

(43) Veröffentlichungstag der Anmeldung:
**15.05.85 Patentblatt 85/20**

(84) Benannte Vertragsstaaten:
**DE FR GB NL**

(71) Anmelder: **Siemens Aktiengesellschaft**
**Berlin und München Wittelsbacherplatz 2**
**D-8000 München 2(DE)**

(72) Erfinder: **Holubarsch, Winfried, Dr.Dipl.-Phys.**
**Bussardstrasse 28**
**D-8025 Unterhaching(DE)**

(54) **Kombinierte Schaltung mit Varistor.**

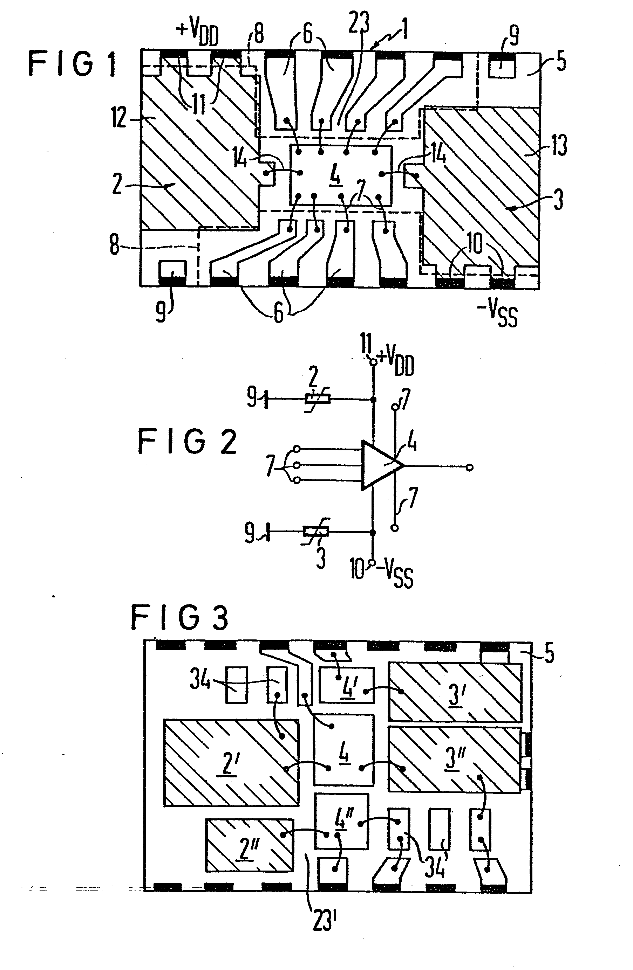

(57) Die in der kombinierten Schaltung (Figur 1) enthaltenen Varistoren (2, 3) sind nur noch Anteile des ursprünglich homogenen Körpers. Die übrigen Bereiche (23) des Substratkörpers (5) sind dadurch wenigstens nahezu elektrisch isolierend, weil sie zusätzlich wenigstens einen diese Eigenschaft bewirkenden Stoff (Lithiumoxid und/oder Manganoxid) enthalten, der entweder nach dem Sintern des Substratkörpers (5) auf deisem oder vor dem Sintern auf dem Grünkörper aufgebracht worden ist und durch weiteren Erhitzungsprozeß (45, 45') bei gegenbenenfalls gleichzeitigem Sintern (Variante 2) in den Körper eindiffundiert ist.

**FIG 4**

EP 0 141 179 A2

SIEMENS AKTIENGESELLSCHAFT          Uunser Zeichen
Berlin   und München                VPA  83 P 1737 E

## Kombinierte Schaltung mit Varistor.

Die vorliegende Erfindung bezieht sich auf eine kombinierte Schaltung, wie sie im Oberbegriff des Patentanspruchs 1 angegeben ist.

Insbesondere zum Schutz gegen Überspannungen ist es bekannt, Schaltungen - vorzugsweise Halbleiterschaltungen - Überspannungshalbleiter zuzuordnen. Hierfür eignen sich besonders Varistoren, die elektrisch mit Zuleitungen jeweiliger Schaltungen verbunden werden.

Vorzugsweise sind Varistoren aus dotierter Zinkoxid-Keramik bestehende Bauelemente mit an bzw. auf dem Keramikkörper befindlichen Elektroden (US-Patent 3 805 114). Bei niedriger anliegender Spannung hat ein Varistor hochohmiges Verhalten und erst bei höherer anliegender Spannung wird er niederohmig. Strom J und Spannung U sind bei einem solchen Bauelement der Gleichung $I = (\frac{U}{K}) \propto$ entsprechend voneinander abhängig, wobei K eine Materialkonstante und $\propto$ der Koeffizient der Nichtlinearität ist. Der Zinkoxid-Keramikkörper eines Varistors kann durch und durch die elektrische Varistoreigenschaft haben. Bekannt sind aber auch solche Varistoren, bei denen nur ein Schichtbereich des Zinkoxid-Keramikkörpers diese Varistoreigenschaft hat (DE-OS 28 20 118, DE-OS 29 21 497). Das Zinkoxid des übrigen Anteils des Keramikkörpers eines solchen Varistors ist spannungsunabhängig stets niederohmig.

Bts 1 Bla / 21.9.1983

83 P 1791 48 179

Hergestellt wird ein solcher Varistor z.B. dadurch, daß zunächst ein spannungsunabhängig niederohmiger Zinkoxid-Keramikkörper hergestellt wird, und zwar durch Mischen der Ausgangssubstanzen, Mahlen des Schlickers, Pressen zu Formkörpern und Sintern der Formkörper. Die Varistoreigenschaft wird dann nachträglich durch Eindiffusion von einem oder mehreren der Dotierungsstoffe, wie z.B. Wismutoxid, Boroxid, Kobaltoxid, Antimonoxid, Chromoxid, Nickeloxid, Zinkoxid, Titanoxid, Praseodymoxid, Kalziumoxid und anderen, erzielt.

Im Zusammenhang mit der Verwendung von Schaltungen, die z.B. reine Halbleiterschaltungen, Hybridschaltungen sind und/oder anderen Aufbau haben können, ist das Bestreben stets danach gerichtet, Überspannungsschutz mit möglichst induktivitätsarmem Aufbau bei möglichst geringem Raumbedarf zu erreichen. Induktivitätsbehafteter Aufbau des Überspannungsschutzes führt zu einer Verminderung der Schutzwirkung bei Überspannungen mit hoher Anstiegsgeschwindigkeit. Auch soll eine jeweilige neue Schaltung mit den technologischen Mitteln und Verfahren herzustellen sein, die schon bisher verwendet wurden und auf die die Produktionsbetriebe eingerichtet sind.

83 108 085.8 Das nichtvorveröffentlichte ältere europäische Patentanmeldung betrifft einen Vorschlag für eine kombinierte Schaltung, bestehend aus einer oder mehreren integrierten Schaltungen, die gegenüber Überspannung zu schützen sind, und einem oder mehreren Varistoren, die zu diesem Schutz vorgesehen sind, wobei diese ganze kombinierte Schaltung induktivitätsarmen Aufbau hat. Diese kombinierte Schaltung hat einen Substratkörper aus hochohmiger Zinkoxid-Keramik, wobei dieser Substratkörper in wenigstens einem Teilbereich zu einer Keramik mit Varistoreigenschaft ausgebildet ist und übrige Bereiche des Substratkörpers unverändert elektrisch wenigstens nahezu isolierend sind. Hergestellt wird eine solche kombinierte Schaltung des älteren Vorschlags dadurch, daß ein Zinkoxid-Substratkörper hergestellt wird, der wenigstens einen Zusatzstoff, Mangan, enthält, durch den das Substratmaterial hochohmige elektrische Eigenschaft erhält. In weiteren Verfahrensschritten werden die für Varistoren vorgesehenen Flächenanteile dieses Substratkörpers mit einem pastösen Gemisch aus Dotierungsstoffen belegt, die dann anschließend in einem Temperprozeß bei entsprechend hohen Temperaturen in das Keramikmaterial eindiffundieren und dort die Varistoreigenschaft bewirken.

Die Varistoren einer kombinierten Schaltung dieses älteren Patents haben gute Varistoreigenschaft insbesondere bei höheren Werten der Varistor-Ansprechspannung. Besonders niedrige Werte der Varistor-Ansprechspannung zu erreichen kann auf Schwierigkeiten stoßen und insbesondere höheren technologischen Aufwand in der Herstellung erforderlich machen.

Es ist eine Aufgabe der vorliegenden Erfindung, eine dem älteren Patent entsprechende kombinierte Schaltung mit Varistor anzugeben, für die insbesondere ohne technologischen Mehraufwand eine freiere Wahl der Höhe der Varistor-Ansprechspannung besteht.

Diese Aufgabe wird mit einer Schaltung nach dem Patentanspruch 1 bzw. mit den Merkmalen des Verfahrens-Hauptanspruches gelöst.

Die vorliegende Erfindung bzw. die vorliegende Verbesserung der Erfindung des älteren nichtvorveröffentlichten Patents beruht auf der Erkenntnis, daß eine kombinierte Schaltung nach dem älteren Patent im Regelfall einen Substratkörper mit relativ feinkörnigem Gefüge hat, und daß dies dazu führt, daß die ohne weiteres sehr guten Varistoreigenschaften jedoch vorzugsweise bei solchen Ausführungsformen der Erfindung vorliegen, deren Varistor-Ansprechspannung im Bereich höherer Spannungswerte liegen. Es wurde gefunden, daß insbesondere für den Bereich niedriger Varistor-Ansprechspannungen es technologisch günstiger ist, von einem Substratkörper auszugehen, der durchwegs Varistoreigenschaft besitzt und in diesem Varistor-Substratkörper diejenigen hochohmigen Bereich zu erzeugen, die für den Aufbau der kombinierten Schaltung notwendig sind bzw. in denen elektrische Leitfähigkeit, unabhängig von der auftretenden elektrischen Spannung, unerwünscht ist.

Indem man für den Zinkoxid-Körper nach der Erfindung von einem Zinkoxid ausgeht, das die für den Varistoreffekt notwendigen, an sich bekannten Dotierungsstoffe, wie Kobalt-, Antimon-, Chrom-, Titan-, Wismut-, Nickel-, Zinn- Bor- und/oder Praseodymoxide, enthält, kommt man schließlich zu einem Substratkörper, dessen Gefüge in prinzipiell an sich bekannter Weise je nach Wahl der Kombination der Zugabe- Elemente und der Sinterbedingungen mehr feinkörnig oder mehr grobkörnig ist. Für grobkörnigeren Substratkörper läßt sich niedrigere Varistor-Ansprechspannung erreichen.

Bei der Erfindung wird in einem weiteren Verfahrensschritt ein aus dem dotierten Zinkoxid hergestellter Körper auf seiner Oberfläche nachfolgend in den Bereichen, in denen dieser Körper schließlich hochohmig sein soll, mit einem pastösen Gemisch aus einem solchen Stoff belegt, der in einem anschließend durchzuführenden Erhitzungsprozeß bei Temperaturen von über 1000°C diese Hochohmigkeit erreichen läßt. Insbesondere ist ein solcher Stoff Mangan-, Wismut- oder Lithiumoxid oder ein Gemisch aus wenigstens zwei dieser Oxide. Für diesen Herstellungsprozeß wurden zwei Varianten gefunden, nämlich daß der oben erwähnte Körper aus dotiertem Zinkoxid, der mit dem pastösen Stoff zum Erreichen der Hochohmigkeit belegt wird, ein Grünkörper (noch nicht zu Keramik gesinterter Körper) ist. Der erwähnte Erhitzungsprozeß wird dann bei vorzugsweise 1100 bis 1380°C durchgeführt, wobei auch die Sinterung des Grünkörpers zum gesinterten Substratkörper erfolgt. Dieser Substratkörper hat dann die aufgrund der Dotierung erreichte Varistoreigenschaft und in den mit pastösem Stoff belegten Bereichen hochohmige Eigenschaft, weil während dieses Sinterprozesses dieser Stoff in den sinternden Grünkörper eindringt. Entsprechend einer anderen Alternative erfolgt die an sich bekannte Sinterung vor dem Belegen mit dem pastösen Stoff, so daß ein Keramikkörper mit zunächst durchwegs Varistoreigenschaft entsteht, der im nachfolgenden Erhitzungsprozeß bei Temperaturen über 1000°C, wiederum aufgrund des Eindringens des pastösen Stoffes in das Körpervolumen, in diesen Bereich die Hochohmigkeit erhält, und zwar ohne Verlust der Varistoreigenschaften in den auf der Oberfläche nicht belegten Bereichen des Substratkörpers.

Weitere Erläuterungen zur Erfindung gehen aus der nachfolgenden, anhand der Figuren gegebenen Beschreibung hervor. Es zeigen:

Fig.1 eine erfindungsgemäße kombinierte Schaltung,

Fig.2 das zugehörige Schaltbild,

Fig.3 eine Übersichtsdarstellung einer erfindungsgemäßen
Hybridschaltung und

Fig.4 ein Flußdiagramm zum Herstellungsverfahren in seinen beiden Varianten.

Fig.1 zeigt mit 1 bezeichnet ein Beispiel einer erfindungsgemäßen Kombinationsschaltung mit zwei Varistoren
2 und 3 und einer integrierten Schaltung 4. Diese integrierte Schaltung 4 ist z.B. ein Halbleiterplättchen, in
dem sich die elektronischen Strukturen befinden und das
auf in der Fig.1 oberen Oberfläche des Substratkörpers 5
aus elektrisch isolierender Zinkoxid-Keramik angebracht
ist. Mit 6 sind Leiterbahnen bezeichnet, die bis an den
jeweils benachbarten Rand des Substratkörpers 5 reichen
und dort Anschlußkontakte bilden. Diese Leiterbahnen reichen bis nahe an die Schaltung 4 heran und sind jeweils
mit den zugehörigen Kontakten dieser Schaltung 4 durch
Drahtverbindungen 7 elektrisch verbunden.

Unterhalb dieser durch Schraffur hervorgehobenen Teilbereiche der Varistoren 2 und 3 hat das Zinkoxid-Material
des Substratkörpers 5 die ursprüngliche Varistoreigenschaft.
In Bereichen 23 außerhalb dieser Teilbereiche 2, 3 ist der
Substratkörper zumindest im Bereich seiner Oberfläche so
hochohmig, daß er dort wenigstens nahezu elektrisch isolierend ist.

Die beiden mit 8 bezeichneten, in der Fig.1 gestrichelt
eingetragenen Linien sind die Begrenzungen für eine auf
der Rückseite des Substratkörpers 5 angebrachte Metallisierung, die in erster Linie als Gegenelektrode für die Varistoren 2 und 3 verwendet wird und außerdem auch als rückwärtige elektrische Abschirmung der integrierten Schaltung 4 dient. Auf denjenigen Anteilen der Rückseite des Substratkörpers 5, die auf der Vorderseite des Substratkörpers 5 angebrachten Leiterbahnen gegenüberliegen, ist vorzugsweise keine Metallisierung (der Rückseite) vorgesehen, um unnötige zusätzliche Kapazitäten zu vermeiden. Sollten solche Kapazitäten jedoch nicht stören, können, sofern z.B. elektrische Abschirmung gewünscht wird, weitere Anteile der Rückseite des Substratkörpers 5 metallisiert sein. Diese rückseitige Metallisierung des Substratkörpers im Bereich zwischen den Linien 8 wird im Regelfall an Masse angeschlossen, wozu die Anschlußkontakte 9 vorhanden sind. Mit 10 und 11 sind die Anschlußkontakte des Substratkörpers bezeichnet, die für den Anschluß der elektrischen Versorgungsspannung vorgesehen sind. Diese Kontakte 10 und 11 sind mit den auf der Vorderseite des Substratkörpers 5 aufgebrachten Elektroden 12 bzw. 13 elektrisch verbunden, die zum besseren Erkennen durch Schraffur hervorgehoben sind. Diese Elektroden 12 bzw. 13 sind deckungsgleich mit den voranstehend erwähnten Varistoren 2 und 3, soweit diesen Elektroden 12, 13 auf der Rückseite des Substratkörpers 5 eine Gegenelektrode 8 gegenüberliegt.

Mit 14 sind die elektrischen Drahtverbindungen zwischen dem jeweiligen Varistor und der Schaltung 4 bezeichnet. Diese Verbindungen sind extrem kurz, so daß deren Eigeninduktivität minimal ist.

Fig.2 zeigt ein elektrisches Schaltbild zum Aufbau der Fig.1. Die Schaltungssymbole der Fig.2 haben dieselben Bezugszeichen, die das gleiche elektronische Bauteil in der Anordnung der Fig.1 hat. Aus dem Schaltbild der Fig.2 ist zu erkennen, wie die die Schaltung 4 vor Überspannung schützenden Varistoren 2 und 3 elektrisch (in an sich bekannter Weise) in der Gesamtschaltung ange-

schlossen sind.

Ein Vorteil eines wie dargestellten erfindungsgemäßen Aufbaues ist, daß die von vorveröffentlichten Schaltungen her bekannten hohen Eigeninduktivitäten der Anschlußleitungen der Varistoren hier praktisch vollständig wegfallen, so daß die Varistoren die integrierte Schaltung auch vor sehr steilen Überspannungsstößen schützen können.

Fig.3 zeigt lediglich eine Übersichtsdarstellung zu einer erfindungsgemäßen Ausführungsform mit einer Hybridschaltung mit mehreren integrierten Schaltungen 4, 4', 4" und weiteren Einzelbauelementen 34. Zugehörige Varistoren, die integr,erte Bestandteile des Substratkörpers 5' sind, sind mit 2 , 2" bzw. 3', 3" bezeichnet. Die hochohmigen, wenigstens nahezu isolierenden Bereiche sind mit 23' bezeichnet. Obige Einzelbauelemente können z.B. Vielschicht-Kondensatoren, Widerstände und dergleichen sein.

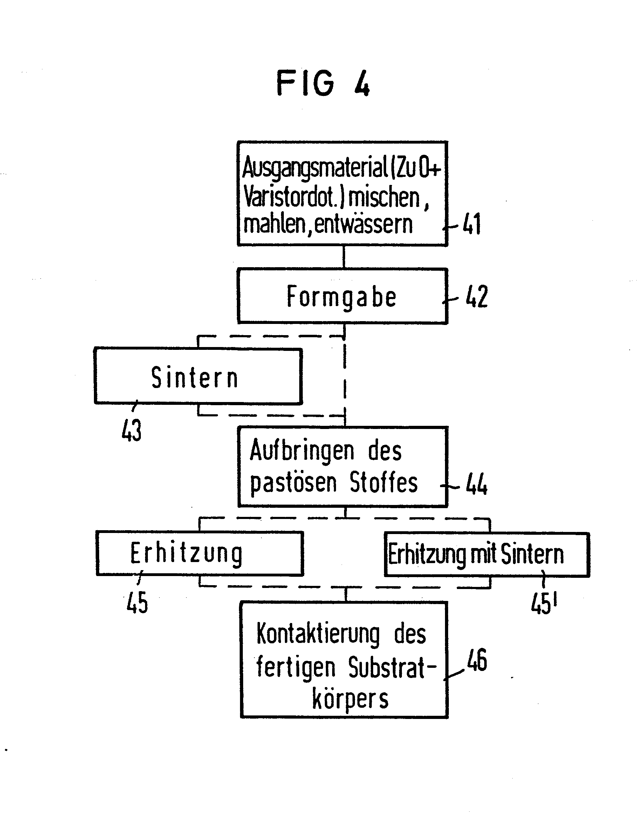

Fig.4 zeigt ein Flußdiagramm zum Herstellungsverfahren mit seinen Varianten. Es wird pulverförmiges Zinkoxid mit den für die Varistoreigenschaften vorgesehenen bekanntermaßen zu verwendenden Dotierungsstoffe in wässrigem Schlicker gemischt und gemahlen (41), entwässert und mit einem Plastifizierungsmittel, wie z.B. Polyviol, versetzt. Als Dotierungsstoffe können bekanntermaßen für Varistor-Keramik verwendete Kobalt-, Antimon-, Chrom-, Titan-, Wismut-, Bor-, Nickel-, Zinn- und/oder Praseodymoxide zugegeben werden. Es werden dann plattenförmige Grünkörper mit Dickenabmessungen zwischen 0,2 und 1 mm in der gewünschten Größe hergestellt, z.B. durch Formpressen oder Bandzieh-Verfahren (42). Entsprechend der ersten Variante werden die getrockneten Rohplatten, d.h. die Grünkörper, bei Temperaturen zwischen 1100°C und 1380°C in Luft gesintert (43). Hierbei entsteht Varistor-Keramik.

Die plattenförmigen Grünkörper (zweite Variante) bzw. die hergestellten gesinterten Platten (erste Variante) werden nunmehr beispielsweise im Siebdruck-Verfahren mit einem pastösen Stoff, vorzugsweise Mangan-, Wismut- oder Lithiumoxid oder ein Gemisch aus wenigstens zwei dieser Oxide, vorzugsweise unter Verwendung organischen Bindemittels, in den Bereichen bedruckt (44), in denen später hochohmiges Verhalten vorliegen soll. Es sind dies im Regelfall alle Bereiche des Substratkörpers 5, ausgenommen die Varistoren 2 und 3. Nachdem das aufgedruckte pastöse Gemisch getrocknet ist, erfolgt die Bildung dieser hochohmigen Bereiche (erste Variante) bzw. auch das Sintern (zweite Variante) in dem Erhitzungsprozeß 45, 45' in oxidierender Atmosphäre bei Temperaturen zwischen 1000 und 1380°C bei der ersten Variante und zwischen 1100 und 1380°C bei der zweiten Varianten.

Die wie zur Fig.1 ausführlich beschrieben vorgesehenen Elektroden-Metallisierungen 12, 13 der Varistoren 2, 3 werden z.B. durch Aufdampfen, Aufsputtern oder Siebdrucken mit Einbrennen entsprechender Metalle hergestellt 46. Dabei werden auch gleichzeitig die Anschluß-Leiterbahnen 6 und andere Kontakte und Leiterbahnen 9, 10 und 11 hergestellt. Ein Substratkörper 5 ist damit fertig hergestellt zur Bestückung mit den entsprechenden integrierten Schaltungen und mit gegebenenfalls zusätzlich vorgesehenen elektronischen Bauelementen.

## Patentansprüche:

1. Kombinierte Schaltung mit wenigstens einem elektronischen Bauelement, das zum Schutz gegen Überspannungen elektrisch mit wenigstens einem Varistor verbunden ist, wobei sich diese Kombinationsschaltung auf und in einem Substratkörper aus Zinkoxid-Keramik befindet, wobei dieser Substratkörper in wenigstens einem Teilbereich Varistoreigenschaft hat und andere Bereiche des Substratkörpers elektrisch wenigstens nahezu isolierend sind, nach Patent 32 31 118,
g e k e n n z e i c h n e t dadurch,
daß das Zinkoxid in dem elektrisch wenigstens nahezu isolierendem Bereich (23) des Substratkörpers (5) die an sich für die Varistoreigenschaft der Teilbereiche (2, 3) vorgesehenen Dotierungselemente und/oder Wismutoxid enthält.

2. Kombinierte Schaltung nach Anspruch 1, g e k e n n z e i c h n e t dadurch, daß der Substratkörper (5) in dem isolierenden Bereich (23) Lithiumoxid und/oder Mangan- oxid enthält.

3. Kombinierte Schaltung nach Anspruch 2, g e k e n n z e i c h n e t dadurch, daß dieser Gehalt 1 bis 5 Gew.% beträgt.

4. Verfahren zur Herstellung einer Schaltung nach einem der Ansprüche 1 bis 3, g e k e n n z e i c h n e t dadurch,
daß zunächst in an sich bekannter Weise ein plattenförmiger Körper (5) aus Zinkoxid und den zur Erzeugung der Varistoreigenschaft zu verwendenden Dotierungsstoffen hergestellt wird (41-43 bzw. 41 und 42),
daß des weiteren für den wenigstens nahezu isolierenden

83 P 1 7 3 7 E **0141179**

Bereich (23) die entsprechenden Flächenanteile dieses Körpers (5) mit einem pastösen Stoff belegt werden (44) und

daß anschließend ein Erhitzungsprozeß (45, 45') bei Temperaturen oberhalb etwa 1000°C durchgeführt wird.

5. Verfahren nach Anspruch 4, g e k e n n z e i c h n e t dadurch, daß der Erhitzungsprozeß (43) als für die Eindiffusion des pastösen Stoffes vorgesehener Tempervorgang bei Temperaturen von 1000° bis 1380°C durchgeführt wird, wobei für die Herstellung des Körpers bereits ein Sinterprozeß (43) bei 1100° bis 1380°C zuvor durchgeführt worden ist.

6. Verfahren nach Anspruch 4, g e k e n n z e i c h n e t dadurch, daß der Erhitzungsprozeß (45') als Tempervorgang für die Eindiffusion des pastösen Stoffes und als gleichzeitiger Sinterprozeß für den Grünkörper bei Temperaturen von 1100° bis 1380°C durchgeführt wird.

7. Verfahren nach Anspruch 4, 5 oder 6, g e k e n n z e i c h n e t dadurch, daß Lithiumoxid und/oder Mangan- und/oder Wismutoxid als pastöser Stoff bzw. als pastöses Gemisch aufgebracht wird (44).

FIG 1

FIG 2

FIG 3

# FIG 4

```
┌──────────────────────────┐
│ Ausgangsmaterial(ZnO+    │
│ Varistordot.)mischen,    │── 41
│ mahlen,entwässern        │
└──────────────────────────┘
              │
┌──────────────────────────┐
│        Formgabe          │── 42
└──────────────────────────┘
              │
┌──────────────────────────┐
│        Sintern           │
└──────────────────────────┘
    43
              │
┌──────────────────────────┐
│   Aufbringen des         │
│   pastösen Stoffes       │── 44
└──────────────────────────┘
              │
┌──────────────────┐    ┌──────────────────────────┐
│   Erhitzung      │    │ Erhitzung mit Sintern    │
└──────────────────┘    └──────────────────────────┘
    45                                      45'
              │
┌──────────────────────────┐
│   Kontaktierung  des     │
│   fertigen Substrat-     │── 46
│   körpers                │
└──────────────────────────┘
```